# EUROPEAN PATENT APPLICATION

(11) **EP 4 428 897 A1**
(43) Date of publication of application: **11.09.2024**
(21) Application number: 21963424.3
(22) Date of filing: 02.12.2021
(51) Int. Cl.: H01J 37/32, H01L 21/67

(54) **UPPER ELECTRODE UNIT AND SUBSTRATE PROCESSING APPARATUS COMPRISING SAME**

(30) Priority: 02.11.2021 KR 20210149134
(71) Applicant: PSK Inc., Hwaseong-si, Gyeonggi-do 18449 (KR)
(72) Inventor: YOO, Kwang Sung, Hwaseong-si Gyeonggi-do 18449 (KR); LEE, Jong Chan, Hwaseong-si Gyeonggi-do 18449 (KR); NAM, Seong Min, Hwaseong-si Gyeonggi-do 18449 (KR)
(74) Representative: Harrison IP Limited
(86) International application number: PCT/KR2021/018053
(87) International publication number: WO 2023/080324

(57) **Abstract**

The present invention provides a substrate processing apparatus. The substrate processing apparatus comprises: a housing having an inner space; a lower electrode unit supporting a substrate in the inner space; an upper electrode unit facing the lower electrode unit; and a gas supply unit supplying a processing gas into the inner space, wherein the upper electrode unit may comprise: a dielectric plate facing the upper surface of the substrate that is supported by the lower electrode unit; a support body supporting the dielectric plate, the support body and the dielectric plate being combined with each other to form a buffer space and the gas supply unit supplying the processing gas into the inner space via the buffer space; and a baffle ring which is disposed on a flow path of the processing gas which flows from the buffer space to the inner space.

## Description

### [Technical Field]

The present disclosure relates to an upper electrode unit and a substrate processing apparatus including the same.

### [Background Art]

Plasma refers to an ionized gas state composed of ions, radicals, electrons, or the like. Plasma is generated by a very high temperature, a strong electric field, or a radio frequency (RF) electromagnetic field. A semiconductor device manufacturing process includes an ashing or etching process for removing a layer on a substrate, such as a wafer, by using plasma. The ashing or etching process is performed as ions and radical particles contained in plasma collide or react with a film material on a substrate.

An apparatus for processing a substrate by using plasma, for example, a plasma etch apparatus, has a housing having a processing space. In addition, the apparatus for processing a substrate supplies a process gas to the processing space, and excites the process gas to generate plasma. The process gas may include various types of gases. For example, the process gas may be a gas including N2 and CF4. In order to improve the uniformity of plasma processing for a substrate, it is important to sufficiently mix various types of gases included in the process gas. Otherwise, the degree of excitation into a plasma state may vary depending on the degree of mixing of the gases, and in this case, a problem of deterioration of plasma processing uniformity occurs.

Also, among plasma etch apparatuses, a bevel etch apparatus for processing an edge region of a substrate generally uses a single gas supply line to supply a process gas to the edge region of the substrate. However, when the process gas is supplied through a single gas supply line, it is difficult to supply the process gas at a uniform flow amount and flow rate, and it is difficult to sufficiently mix various types of gases included in the process gas.

### [Technical Problem]

An object of the present disclosure is to provide an upper electrode unit capable of efficiently processing a substrate, and a substrate processing apparatus including the same.

Another object of the present disclosure is to provide an upper electrode unit capable of improving the uniformity of processing by plasma, and a substrate processing apparatus including the same.

Another object of the present disclosure is to provide an upper electrode unit capable of sufficiently mixing a process gas excited to a plasma state, and a substrate processing apparatus including the same.

Another object of the present disclosure is to provide an upper electrode unit capable of sufficiently mixing a process gas while the process gas is supplied, and a substrate processing apparatus including the same.

The problem to be solved by the present disclosure is not limited to the above-mentioned problems, and problems not mentioned can be clearly understood by those of ordinary skill in the art to which the present disclosure belongs from the present specification and the accompanying drawings.

### [Technical Solution]

The present disclosure provides an apparatus for processing a substrate, that is, a substrate processing apparatus. The substrate processing apparatus includes a housing having an interior space, a lower electrode unit supporting a substrate in the interior space, an upper electrode unit facing the lower electrode unit, and a gas supply unit supplying a process gas to the interior space, wherein the upper electrode unit includes a dielectric plate facing an upper surface of the substrate supported by the lower electrode unit, a support body supporting the dielectric plate, wherein the support body and the dielectric plate are combined with each other to form a buffer space and the gas supply unit supplies the process gas to the interior space via the buffer space, and a baffle ring disposed on a flow path of the process gas flowing from the buffer space to the interior space.

A space in which the support body and the dielectric plate are apart from each other may defined as a gas channel through which the process gas flows, the gas channel being in fluid communication with the internal space, and the baffle ring may be disposed in the buffer space.

The baffle ring may include a porous material to allow the process gas to flow.

The baffle ring may include a porous ceramic having a plurality of through holes through which the process gas flows.

The baffle ring may include a perforated plate having a through hole through which the process gas flows.

The baffle ring may include a material including a metal.

The upper electrode unit may further include an upper edge electrode supported by the support body and provided to surround the dielectric plate when viewed from above.

A diameter of an inner periphery of the upper edge electrode viewed from above may be greater than a diameter of an outer periphery of the dielectric plate.

A space in which the upper edge electrode and the dielectric plate are apart from each other may be defined as a gas discharge unit that discharges the process gas flowing through the gas channel to an edge region of the substrate supported by the lower electrode unit, the gas discharge unit being in fluid communication with the gas channel and the interior space.

The lower electrode unit may include a chuck supporting the substrate, an insulating ring configured to surround the chuck when viewed from above, and a lower edge electrode configured to surround the insulating ring when viewed from above.

The lower electrode unit may further include a power member configured to apply radio frequency (RF) power to the chuck.

The gas supply unit may include a gas supply source supplying the process gas in which a plurality of gases of different types are mixed, and a gas supply line supplying the process gas to the buffer space.

The gas supply source may be configured to supply the process gas including at least two of O2, N2, Ar, SF6, and CF4.

The present disclosure provides an upper electrode unit of a bevel etch apparatus for processing an edge region of a substrate. The upper electrode unit includes a dielectric plate facing the substrate, a support body supporting the dielectric plate, wherein the support body and the dielectric plate define a buffer space that is a space to which a process gas including at least two different types of gases is supplied, and a baffle ring disposed on a flow path of the process gas flowing from the buffer space toward an edge region of the substrate.

A space in which the support body and the dielectric plate are apart from each other may be defined as a gas channel through which the process gas flows, and the baffle ring may be disposed in the buffer space.

The baffle ring may include a porous material having a plurality of through holes through which the process gas flows.

The baffle ring may include a perforated plate having a through hole through which the process gas flows.

The through hole may be formed in an inclined direction when viewed from a front cross-section.

The upper electrode unit may further include an upper edge electrode supported on an edge region of the support body when viewed from above and configured to surround the dielectric plate.

The upper edge electrode and the dielectric plate may be apart from each other when viewed from above, and a space in which the upper edge electrode and the dielectric plate are apart from each other may be defined as a gas discharge unit that discharges the process gas flowing through the gas channel to an edge region of the substrate.

### [Advantageous Effects of Disclosure]

According to an embodiment of the present disclosure, a substrate may be efficiently processed.

In addition, according to an embodiment of the present disclosure, the uniformity of treatment by plasma may be improved.

In addition, according to an embodiment of the present disclosure, a process gas excited to a plasma state may be sufficiently mixed.

In addition, according to an embodiment of the present disclosure, a process gas may be sufficiently mixed while the process gas is supplied.

Effects of the present disclosure are not limited to the above-mentioned effects, and effects not mentioned can be clearly understood by those of ordinary skill in the art to which the present disclosure belongs from the present specification and the accompanying drawings.

### [Description of Drawings]

FIG. 1 is a view schematically illustrating a substrate processing equipment according to an embodiment of the present disclosure.
FIG. 2 is a cross-sectional view illustrating an embodiment of a substrate processing apparatus provided in a process chamber of FIG. 1.
FIG. 3 is a view illustrating an example of a baffle ring of FIG. 2.
FIG. 4 is a view illustrating an example in which the substrate processing apparatus of FIG. 2 performs a plasma processing process.
FIG. 5 is a view illustrating another example of the baffle ring of FIG. 2.
FIG. 6 is a view for explaining the structure of another example of the baffle ring of FIG. 2.
FIG. 7 is a view illustrating a part of a cross-section of the baffle ring for explaining the structure of another example of the baffle ring of FIG. 2.
FIG. 8 is a view illustrating a part of a cross-section of the baffle ring for explaining the structure of another example of the baffle ring of FIG. 2.

### [Best Mode]

Hereinafter, with reference to the accompanying drawings, embodiments of the present disclosure will be described in detail so that those of ordinary skill in the art may easily implement them. However, the present disclosure may be implemented in several different forms and is not limited to the embodiments described herein. In addition, in describing a preferred embodiment of the present disclosure in detail, if it is determined that a detailed description of a related known function or configuration may unnecessarily obscure the gist of the present disclosure, the detailed description thereof will be omitted. In addition, the same reference numerals are used throughout the drawings for parts having similar functions and operations.

When a portion "includes" an element, another element may be further included, rather than excluding the existence of the other element, unless otherwise described. Further, the terms such as "include", "comprise", or "have" in the present disclosure are used to specify the existence of features, numbers, processes, operations, components, parts recited in the detailed description, or combinations thereof, and thus should not be understood as pre-excluding the existence or possibility for addition of one or more other features, numbers, processes, operations, components, parts, or combinations thereof.

The singular expression includes plural expressions unless the context clearly implies otherwise. In the drawings, the size or thickness of each component may be exaggerated for clarity.

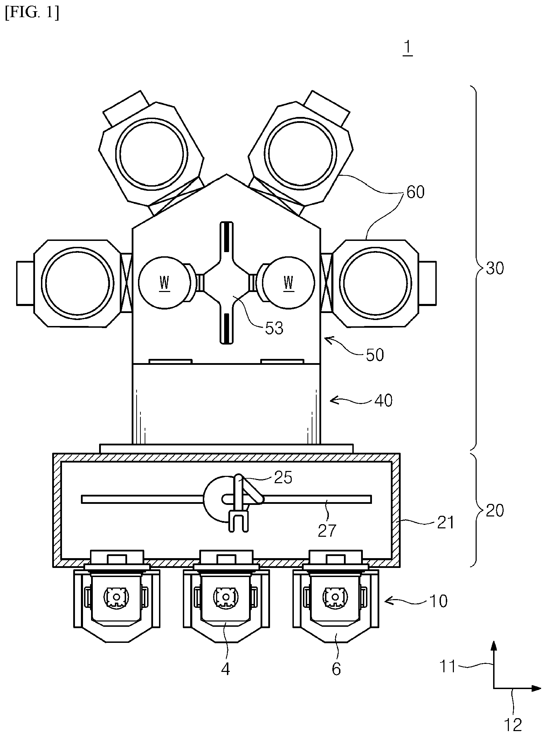

Hereinafter, an embodiment of the present disclosure will be described in detail with reference to FIGS. 1 to 8.

FIG. 1 is a view schematically illustrating a substrate processing equipment according to an embodiment of the present disclosure. Referring to FIG. 1, a substrate processing equipment 1 includes an equipment front-end module (EFEM) 20 and a processing module 30. The EFEM 20 and the processing module 30 are arranged in one direction.

The EFEM 20 has a load port 10 and a transfer frame 21. The load port 10 is disposed in front of the EFEM 20 in a first direction 11. The load port 10 has a plurality of support units 6. The support units 6 are arranged in a line in a second direction 12, and a carrier 4 (e.g., cassette or FOUP) in which a substrate W to be provided for a process and a substrate W on which the process is completed are accommodated is seated on each of the support units 6. The carrier 4 accommodates the substrate W to be provided for the process and the substrate W on which the process is completed. The transfer frame 21 is disposed between the load port 10 and the processing module 30. The transfer frame 21 includes a first transfer robot 25 disposed therein and transferring the substrate W between the load port 10 and the processing module 30. The first transfer robot 25 moves along a transfer rail 27 provided in the second direction 12 and transfers the substrate W between the carrier 4 and the processing module 30.

The processing module 30 includes a load lock chamber 40, a transfer chamber 50, and a process chamber 60. The processing module 30 may receive the substrate W from the EFEM 20 and process the substrate W.

The load lock chamber 40 is disposed adjacent to the transfer frame 21. For example, the load lock chamber 40 may be disposed between the transfer chamber 50 and the EFEM 20. The load lock chamber 40 provides a space for waiting before the substrate W to be provided for the process is transferred to the process chamber 60, or before the substrate W on which the process is completed is transferred to the EFEM 20.

The transfer chamber 50 may transfer the substrate W. The transfer chamber 50 is disposed adjacent to the load lock chamber 40. The transfer chamber 50 has a polygonal body when viewed from above. Referring to FIG. 1, the transfer chamber 50 has a pentagonal body when viewed from above. A load lock chamber 40 and a plurality of process chambers 60 are disposed on the outside of the body along the circumference of the body. A passage (not shown) through which the substrate W enters and exits is formed on each sidewall of the body, and the passage connects the transfer chamber 50 to the load lock chamber 40 or the process chambers 60. Each passage is provided with a door (not shown) that opens and closes the passage to seal the inside. A second transfer robot 53 for transferring the substrate W between the load lock chamber 40 and the process chambers 60 is disposed in an internal space of the transfer chamber 50. The second transfer robot 53 transfers an unprocessed substrate W waiting in the load lock chamber 40 to the process chamber 60, or transfers a processed substrate W to the load lock chamber 40. In addition, the second transfer robot 53 may load the substrate W into an interior space 102 of a housing 100 to be described below, or may unload the substrate W from the interior space 102. In addition, the second transfer robot 53 may transfer substrates W between the process chambers 60 in order to sequentially provide the substrates W to the plurality of process chambers 60. As shown in FIG. 1, when the transfer chamber 50 has a pentagonal body, the load lock chamber 40 is disposed on a side wall adjacent to the EFEM 20, and the process chambers 60 are sequentially disposed on the remaining sidewalls. The transfer chamber 50 may be provided in various forms depending on a required process module as well as the above shape.

The process chamber 60 may be disposed adjacent to the transfer chamber 50. The process chamber 60 is disposed along the circumference of the transfer chamber 50. A plurality of process chambers 60 may be provided. In each of the process chambers 60, a process for the substrate W may be performed. The process chamber 60 receives a substrate W from the second transfer robot 53 to process the substrate W, and provides a processed substrate W to the second transfer robot 53. Processes performed in the process chambers 60, respectively may be different from each other.

Hereinafter, a substrate processing apparatus performing a plasma process in the process chamber 60 is described. In addition, the case in which the substrate processing apparatus is configured to perform a plasma processing process on an edge region of a substrate in the process chamber 60 is described below as an example. However, the present disclosure is not limited thereto, and the substrate processing apparatus described below may be equally or similarly applied to various chambers in which substrate processing is performed. Also, the substrate processing apparatus may be equally or similarly applied to various chambers in which a plasma processing process for a substrate is performed.

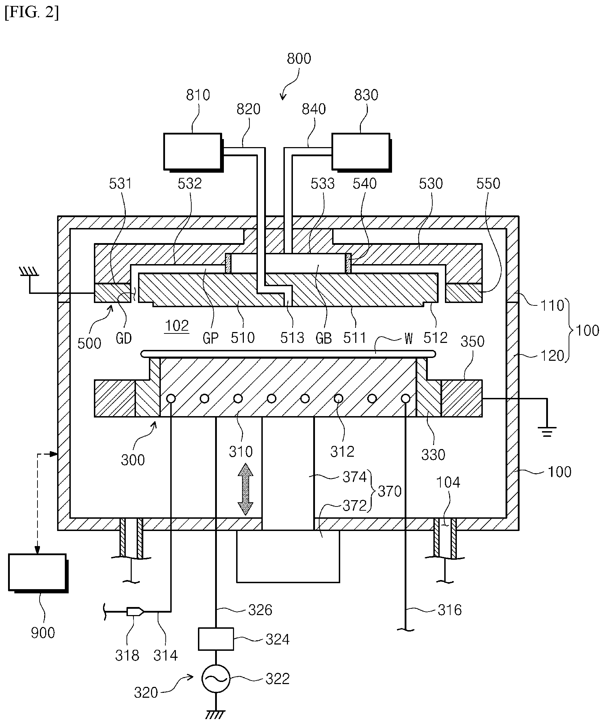

FIG. 2 is a view illustrating an embodiment of a substrate processing apparatus provided in the process chamber 60 of FIG. 1.

Referring to FIG. 2, the substrate processing apparatus provided in the process chamber 60 performs a predetermined process on a substrate W by using plasma. For example, the substrate processing apparatus may etch or ash a film material on the substrate W. The film material may be of various types, such as a polysilicon film, a silicon oxide film, and a silicon nitride film. In addition, the film material may be a natural oxide film or a chemically generated oxide film. In addition, the film material may be a by- product generated in the process of processing the substrate W. In addition, the film material may be impurities attached and/or remaining on the substrate W.

The substrate processing apparatus may perform a plasma process on the substrate W. For example, the substrate processing apparatus may process the substrate W by supplying a process gas and generating plasma from the supplied process gas. The substrate processing apparatus may process an edge region of the substrate W by supplying a process gas and generating plasma from the supplied process gas. Hereinafter, the substrate processing apparatus is described as an example of a bevel etch apparatus performing an etching process on the edge region of the substrate W.

The substrate processing apparatus may include a housing 100, a lower electrode unit 300, an upper electrode unit 500, a gas supply unit 800, and a controller 900.

The housing 100 may define the interior space 102. The housing 100 may include an upper housing 110 (e.g., a first housing) and a lower housing 120 (e.g., a second housing). The upper housing 110 and the lower housing 120 may be combined with each other to define the interior space 102. In addition, the upper housing 110 may be rotatably fastened to the lower housing 120 by a rotation coupling unit (not shown). For example, the upper housing 110 and the lower housing 120 may be fastened to each other by a rotation coupling unit that may be a hinge mechanism.

The upper housing 110 may be in an open position, or may be in a closed position. Hereinafter, the position of the upper housing 110 in which the upper housing 110 is combined with the lower housing 120 to define the interior space 102 is referred to as a closed position, and the position of the upper housing 100 in which the interior space 102 is exposed to the outside is referred to as an open position.

In addition, the atmosphere of the internal space 102 is isolated from the outside when the upper housing 110 is in the closed position, and the internal space 102 isolated from the outside may be in a low pressure state (vacuum pressure atmosphere) close to vacuum while the substrate W is processed. In addition, the housing 100 may include a material including a metal. Also, the inner surface of the housing 100 may be coated with an insulating material. Also, the housing 100 may be grounded.

Also, the housing 100 may be a vacuum chamber. For example, an exhaust hole 104 may be formed in the bottom surface of the housing 100. Plasma P generated in the interior space 212 or gases G1 and G2 supplied to the interior space 212 may be exhausted to the outside through an exhaust hole 104. In addition, by-products generated in the process of processing the substrate W by using the plasma P may be exhausted to the outside through the exhaust hole 104. The exhaust hole 104 may be connected to an exhaust line (not shown). The exhaust line may be connected with a pressure reducing member providing pressure reduction. The pressure reducing member may provide pressure reduction to the interior space 102 through the exhaust line.

The lower electrode unit 300 may support the substrate W in the interior space 102. The lower electrode unit 300 may include a chuck 310, a power member 320, an insulating ring 330, a lower edge electrode 350, and a driving member 370.

The chuck 310 may support the substrate W in the interior space 102. The chuck 310 may have a support surface for supporting the substrate W. The chuck 310 may have a circular shape when viewed from above. The chuck 310 may have a smaller diameter than the substrate W when viewed from above. Accordingly, a central region of the substrate W supported on the chuck 310 may be seated on the support surface of the chuck 310, and an edge region of the substrate W may not contact the support surface of the chuck 310.

A heating means (not shown) may be provided inside the chuck 310. The heating means (not shown) may heat the chuck 310. The heating means may be a heater. Also, a cooling passage 312 may be formed in the chuck 310. The cooling passage 312 may be formed inside the chuck 310. A cooling fluid supply line 314 and a cooling fluid discharge line 316 may be connected to the cooling passage 312. The cooling fluid supply line 314 may be connected to a cooling fluid supply source 318. The cooling fluid supply source 318 may store a cooling fluid and/or supply the cooling fluid to the cooling fluid supply line 314. Also, the cooling fluid supplied to the cooling passage 312 may be discharged to the outside through the cooling fluid discharge line 316. The cooling fluid stored in and/or supplied by the cooling fluid supply source 318 may be cooling water or cooling gas. In addition, the shape of the cooling passage 312 formed in the chuck 310 is not limited to the shape shown in FIG. 2 and may be variously modified. In addition, a configuration for cooling the chuck 310 is not limited to a configuration for supplying a cooling fluid, and various configurations (e.g., a cooling plate) capable of cooling the chuck 310 may be provided.

The power member 320 may supply radio frequency (RF) power to the chuck 310. The power member 320 may include a power source 322, a matcher 324, and a power line 326. The power source 322 may be a bias power source. Also, the power source 332 may be an RF power source. The power source 322 may be connected to the chuck 310 via the power line 326. Also, the matcher 324 may be provided to the power line 326 to perform impedance matching.

The insulating ring 330 may be provided to have a ring shape when viewed from above. The insulating ring 330 may be configured to surround the chuck 310 when viewed from above. For example, the insulating ring 330 may have a ring shape. The insulating ring 330 may be made of an insulating material. The insulating ring 330 may electrically separate the lower edge electrode 350 from the chuck 310. The chuck 310 may be made of a material including a metal. The insulating ring 330 may be made of an insulating material, such as ceramic.

In addition, the upper surface of the insulating ring 330 may have a stepped shape. The height of an inner upper surface, which is adjacent to a central region of the substrate W, of the upper surface of the insulating ring 330 may be greater than the height of an outer upper surface, which is far from the central region of the substrate W, of the upper surface of the insulating ring 330. In an upper region of an outer upper surface of the insulating ring 330, the inflow of plasma P to be described below is relatively smooth, and in an upper region of an inner upper surface of the insulating ring 330, the inflow of the plasma P is blocked or suppressed. Accordingly, the processing efficiency of an edge region of the substrate W may be further increased.

The lower edge electrode 350 may be configured to surround the insulating ring 330 when viewed from above. The lower edge electrode 350 may have a ring shape when viewed from above. The lower edge electrode 350 may be grounded. The lower edge electrode 350 may be disposed at a position, in which the plasma P may be generated in the edge region of the substrate W supported by the chuck 310, when viewed from above.

The driving member 370 may elevate the chuck 310. The driving member 370 may include an actuator 372 and a shaft 374. The shaft 374 may be coupled with the chuck 310. The shaft 374 may be coupled with the actuator 372. The actuator 372 may raise and lower the chuck 310 in a vertical direction via the shaft 374. As the driving member 370 elevates the chuck 310, the gap between the upper surface of the substrate W supported on the chuck 310 and the lower surface of a dielectric plate 510 to be described below may be adjusted.

The upper electrode unit 500 may be provided to face the lower electrode unit 300. The upper electrode unit 500 may be provided to face the upper surface of the substrate W supported by the lower electrode unit 300. The upper electrode unit 500 may include a dielectric plate 510, a support body 530, a baffle ring 540, and an upper edge electrode 550.

The dielectric plate 510 may be made of a dielectric material. The dielectric plate 510 may be made of a material including ceramic. The dielectric plate 510 may be disposed at a position opposite to the upper surface of the substrate W supported on the chuck 310. The lower surface of the dielectric plate 510 may have a stepped shape. For example, the lower surface of the dielectric plate 510 may include a first lower surface 511 and a second lower surface 512. The first lower surface 511 may be a lower surface adjacent to the central region of the substrate W when viewed from above. The second lower surface 512 may be a lower surface surrounding the first lower surface 511 when viewed from above. The second lower surface 512 may be a lower surface adjacent to the edge region of the substrate W when viewed from above. The height of the first lower surface 511 may be different from the height of the second lower surface 512. For example, the lower surface of the dielectric plate 510 may be stepped so that the height of the first lower surface 511 is less than the height of the second lower surface 512. In a lower region of the second lower surface 512 of the stepped dielectric plate 510, the inflow of the plasma P is relatively smooth, and in an upper region of the first surface 511, the inflow of the plasma P is relatively suppressed. Accordingly, the processing efficiency of the edge region of the substrate W may be further improved.

The support body 530 may support the dielectric plate 510 and the upper edge electrode 550 to be described below. The support body 530 may fix the dielectric plate 510 and the lower edge electrode 550 to be described below to the housing 100. The support body 530 may be made of a material including a metal. The support body 530 may be grounded. The support body 530 may be electrically connected to the housing 100 and be grounded. The support body 530 may be combined with the dielectric plate 510 to thereby form (define) a buffer space GB and a gas channel GP.

The support body 530 may include an edge lower surface 531, a middle lower surface 532, and a center lower surface 533. The edge lower surface 531, the middle lower surface 532, and the center lower surface 533 may be adjacent to the center of the substrate W in this order when viewed from above. The middle lower surface 532 and the center lower surface 533 may be formed to be indented in an upward direction from the lower surface of the support body 530. When viewed from above, the edge lower surface 531 and the middle lower surface 532 may each have a substantially ring shape. An upper edge electrode 550 to be described below may be provided on the edge lower surface 531. The middle lower surface 532 may define the gas channel GP. The center lower surface 533 may define the buffer space GB.

The center lower surface 533 of the support body 530 and the upper surface of a central region of the upper surface of the dielectric plate 510 may be combined with each other to define the buffer space GB. The buffer space GB may be a space to which a process gas supplied by a gas supply unit 800 to be described below is supplied. The process gas supplied to the buffer space GB may be mixed in the buffer space GB.

The middle lower surface 532 of the support body 530 and the upper surface of an edge region of the dielectric plate 510 may be combined with each other to define the gas channel GP. The gas channel GP may function as an intermediate gas flow path through which the process gas supplied to the buffer space GB flows toward the edge region of the substrate W. The gas channel GP may be in fluid communication with the buffer space GB. The gas channel GP may be in fluid communication with a gas discharge unit GD to be described below. The gas channel GP may be in fluid communication with the interior space 102.

An upper edge electrode 550 may be installed on an edge lower surface 531 of the support body 530. A grounded upper edge electrode 550 may be provided on the edge lower surface 531 of the support body 530. The upper edge electrode 550 may be disposed to face the lower edge electrode 350. The upper edge electrode 550 may have a ring shape when viewed from above. The upper edge electrode 550 may be an opposite electrode facing the lower edge electrode 350.

The upper edge electrode 550 may be provided to surround the dielectric plate 510 when viewed from above. The upper edge electrode 550 may be provided to be spaced apart from the dielectric plate 510 when viewed from above. The inner periphery of the upper edge electrode 550 and the outer periphery of the dielectric plate 510 may be combined with each other to define the gas discharge unit GD for supplying a process gas to the edge region of the substrate W.

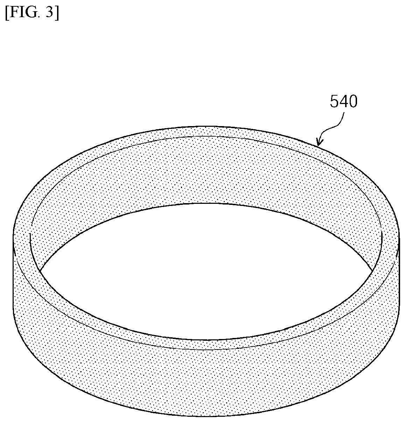

The baffle ring 540 may be disposed on a flow path of the process gas flowing from the buffer space GB to the interior space 102. The baffle ring 540 may have a ring shape when viewed from above. The baffle ring 540 may be disposed in the buffer space GB. The baffle ring 540 may be made of a porous material through which a process gas may flow, as shown in FIG. 3. For example, the baffle ring 540 may be made of a porous ceramic having a plurality of through holes through which a process gas may flow. Accordingly, the process gas supplied to the buffer space GB may be sufficiently mixed in the buffer space GB and then uniformly supplied to the gas channel GP through the through holes formed in the baffle ring 540.

The gas supply unit 800 may supply gas to the interior space 102. The gas supply unit 800 may supply a first gas G1 and a second gas G2 to the interior space 102. The gas supply unit 800 may include a first gas supply unit 810, a first gas supply line 820, a second gas supply unit 830, and a second gas supply line 840.

The first gas supply unit 810 may supply the first gas G1 to the interior space 102. The first gas G1 may be an inert gas, such as nitrogen or argon. The first gas supply unit 810 may supply the first gas G1 to the central region of the substrate W supported on the chuck 310. The first gas supply unit 810 may supply the first gas G1 to the first gas supply line 820. The first gas supply line 820 may have one end connected to the first gas supply unit 810 and the other end in fluid communication with a gas supply end 513 formed in a central region of the dielectric plate 510. The first gas G1 supplied from the first gas supply unit 810 may be supplied to the central region of the substrate W through the first gas supply line 820. The first gas G1 supplied from the first gas supply unit 810 may be supplied to a space between the dielectric plate 510 and the substrate W through the first gas supply line 820.

The second gas supply unit 830 may supply the second gas G2 to the interior space 102. The second gas G2 may be a process gas excited into a plasma state. The second gas G2 may be a process gas in which a plurality of gases of different types are mixed. For example, the second gas supply unit 830 may be configured to supply the second gas G2 including at least two of O2, N2, Ar, SF6, and CF4. The second gas supply unit 830 may supply the second gas G2 to the second gas supply line 840. The second gas supply line 840 may have one end connected to the second gas supply unit 810 and the other end in fluid communication with the buffer space GB. The second gas G1, which is a mixed gas supplied by the second gas supply unit 810, may be supplied to the buffer space GB having a larger volume than the second gas supply line 840 and the gas channel GP, and thus, a flow rate may be reduced. Accordingly, the second gas G2 may be sufficiently mixed in the buffer space GB. The second gas G2 supplied from the second gas supply unit 830 may be supplied to the edge region of the substrate W through the second gas supply line 840.

The controller 900 may control the substrate processing apparatus. The controller 900 may control the substrate processing apparatus to perform a plasma processing process to be performed below.

The controller 900 may control the substrate processing apparatus to perform a substrate processing method described below. In addition, the controller 900 may include a process controller, a user interface, and a storage unit. The process controller may include a microprocessor (computer) that executes the control of the substrate processing apparatus. The user interface may include a keyboard through which an operator performs command input operations and the like to manage the substrate processing apparatus, and/or a display that visualizes and displays the operation status of the substrate processing apparatus. The storge unit may store a control program for executing, under the control of the process controller, processing that is executed in the substrate processing apparatus, and/or a program (i.e., a processing recipe) for executing processing in each component unit according to various types of data and processing conditions. Furthermore, the user interface and the storage unit may be connected to the process controller. The processing recipe may be stored in a storage medium of the storage unit, and the storage medium may be a hard disk, a portable disk, such as a CD- ROM or DVD, or a semiconductor memory, such as a flash memory.

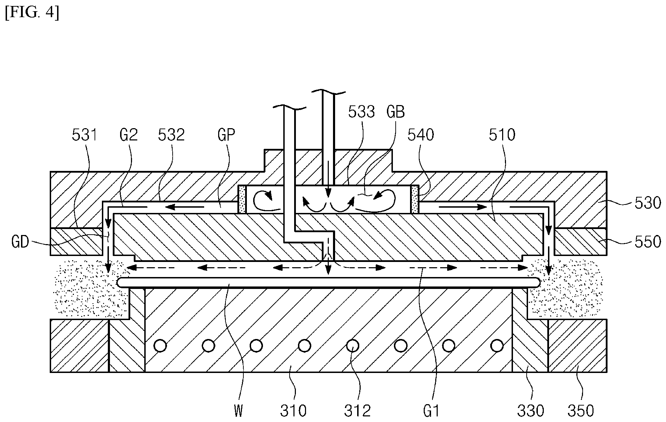

FIG. 4 is a view illustrating an example in which the substrate processing apparatus of FIG. 2 performs a plasma processing process. Referring to FIG. 4, the substrate processing apparatus according to an embodiment of the present disclosure may process an edge region of a substrate W. For example, the substrate processing apparatus may generate plasma P in the edge region of the substrate W to process the edge region of the substrate W. For example, the substrate processing apparatus may perform a bevel etch process for processing the edge region of the substrate W.

In order to perform the bevel etch process on the substrate W, the driving member 370 may move the chuck 310 upward to narrow a gap between the substrate W and the dielectric plate 510.

When the substrate processing apparatus processes the edge region of the substrate W, the first gas supply unit 810 may supply the first gas G1 to the central region of the substrate W, and the second gas supply unit 830 may supply the second gas G2 to the edge region of the substrate W. Because the second gas G2 supplied from the second gas supply unit 830 is a process gas, the second gas G2 may be excited into a plasma P to thereby process the edge region of the substrate W. For example, a thin film on the edge region of the substrate W may be etched by the plasma P. In addition, the first gas G1 supplied to the central region of the substrate W may be an inert gas. The first gas G1 may prevent the second gas G2 from flowing into the central region of the substrate W, and thus, the processing efficiency of the edge region of the substrate W may be further increased.

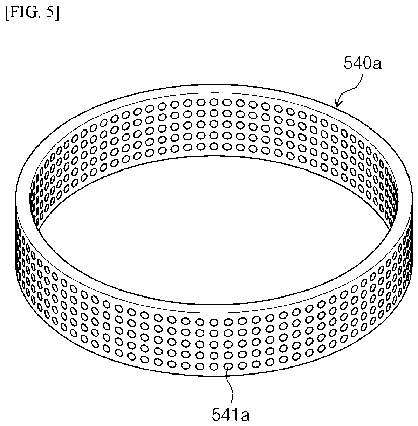

In the above-described example, it has been described that the baffle ring 540 is made of a porous material having a plurality of through holes. However, the present disclosure is not limited thereto. For example, as shown in FIG. 5, a baffle ring 540a according to another embodiment may be provided as a ring-shaped perforated plate in which a plurality of through holes 541a are formed, that is, a mesh-shaped perforated plate. The baffle ring 540a may be made of a material including a metal.

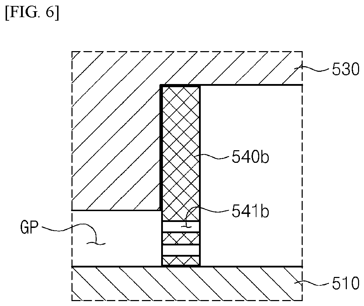

In the above-described example, it has been described that the through holes formed in the baffle rings 540 and 540a are relatively uniformly formed in the entire areas of the baffle rings 540 and 540a. However, the present disclosure is not limited thereto. For example, as shown in FIG. 6, through holes 541b formed in a baffle ring 540b may be formed only in a region facing the gas channel GP.

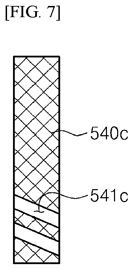

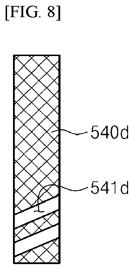

In addition, in the above-described example, it has been described that the through holes 541a and 541b formed in the baffle rings 540a and 540b, respectively are formed in a direction parallel to the horizontal direction. However, the present disclosure is not limited thereto. For example, as shown in FIGS. 7 and 8, through holes 541c and 541d formed in baffle rings 540c and 540d, respectively are formed in a region facing the gas channel GP, but may be formed in a direction inclined with respect to the horizontal direction when viewed from the front cross-section.

In the above-described example, it has been described that the chuck 310 moves in the vertical direction and the positions of the dielectric plate 520 and the upper edge electrode 620 are fixed. However, the present disclosure is not limited thereto. For example, the position of the chuck 310 may be fixed and the dielectric plate 520 may be configured to be movable in the vertical direction. In addition, both the chuck 310 and the dielectric plate 520 may be configured to be movable in the vertical direction.

In addition, in the above-described example, it has been described that the upper edge electrode 620 and the lower edge electrode 350 are grounded. However, the present disclosure is not limited thereto. For example, the upper edge electrode 620 and/or the lower edge electrode 350 may be connected to an RF power source.

The method in which the substrate processing apparatus described in the above-described example generates the plasma P may be an inductive coupled plasma (ICP) method. In addition, the method in which the substrate processing apparatus generates the plasma P may be a capacitor couple plasma (CCP) method. In addition, the substrate processing apparatus may generate the plasma P by using both the ICP method and the CCP method, or using a method selected from the ICP method and the CCP method. Also, the substrate processing apparatus may generate the plasma P by using a remote plasma method.

The above detailed description is illustrative of the present disclosure. In addition, the above description shows and describes preferred embodiments of the present disclosure, and the present disclosure may be used in various other combinations, modifications, and environments. In other words, changes or modifications may be made within the scope of the inventive concept disclosed herein, the scope equivalent to the written disclosure, and/or the scope of skill or knowledge in the art. The above-described embodiments describe the best state for implementing the technical idea of the present disclosure, and various changes required in specific application fields and uses of the present disclosure may be made. Accordingly, the detailed description of the present disclosure is not intended to limit the present disclosure to the disclosed embodiments. Also, the appended claims should be construed as including other embodiments.

## Claims

1. A substrate processing apparatus comprising:
a housing having an interior space;
a lower electrode unit supporting a substrate in the interior space; an upper electrode unit facing the lower electrode unit; and
a gas supply unit supplying a process gas to the interior space, wherein the upper electrode unit comprises:
a dielectric plate facing an upper surface of the substrate supported by the lower electrode unit;
a support body supporting the dielectric plate, wherein the support body and the dielectric plate are combined with each other to form a buffer space and the gas supply unit supplies the process gas to the interior space via the buffer space; and
a baffle ring disposed on a flow path of the process gas flowing from the buffer space to the interior space.

2. The substrate processing apparatus of claim 1, wherein a space in which the support body and the dielectric plate are apart from each other is defined as a gas channel through which the process gas flows, the gas channel being in fluid communication with the internal space, and wherein the baffle ring is disposed in the buffer space.

3. The substrate processing apparatus of claim 1, wherein the baffle ring comprises a porous material to allow the process gas to flow.

4. The substrate processing apparatus of claim 3, wherein the baffle ring comprises a porous ceramic having a plurality of through holes through which the process gas flows.

5. The substrate processing apparatus of claim 1, wherein the baffle ring comprises a perforated plate having a through hole through which the process gas flows.

6. The substrate processing apparatus of claim 5, wherein the baffle ring comprises a material including a metal.

7. The substrate processing apparatus of claim 2, wherein the upper electrode unit further comprises an upper edge electrode supported by the support body and provided to surround the dielectric plate when viewed from above.

8. The substrate processing apparatus of claim 7, wherein a diameter of an inner periphery of the upper edge electrode viewed from above is greater than a diameter of an outer periphery of the dielectric plate.

9. The substrate processing apparatus of claim 8, wherein a space in which the upper edge electrode and the dielectric plate are apart from each other is defined as a gas discharge unit that discharges the process gas flowing through the gas channel to an edge region of the substrate supported by the lower electrode unit, the gas discharge unit being in fluid communication with the gas channel and the interior space.

10. The substrate processing apparatus of any one of claims 7 to 9, wherein the lower electrode unit comprises:
a chuck supporting the substrate;
an insulating ring configured to surround the chuck when viewed from above; and a lower edge electrode configured to surround the insulating ring when viewed
from above.

11. The substrate processing apparatus of claim 10, wherein the lower electrode unit further comprises a power member configured to apply radio frequency (RF) power to the chuck.

12. The substrate processing apparatus of any one of claims 1 to 9, wherein the gas supply unit comprises:
a gas supply source supplying the process gas in which a plurality of gases of different types are mixed; and
a gas supply line supplying the process gas to the buffer space.

13. The substrate processing apparatus of claim 12, wherein the gas supply source is configured to supply the process gas including at least two of O2, N2, Ar, SF6, and CF4.

14. An upper electrode unit of a bevel etch apparatus for processing an edge region of a substrate, the upper electrode unit comprising:
a dielectric plate facing the substrate;
a support body supporting the dielectric plate, wherein the support body and the dielectric plate define a buffer space that is a space to which a process gas including at least two different types of gases is supplied; and
a baffle ring disposed on a flow path of the process gas flowing from the buffer space toward an edge region of the substrate.

15. The upper electrode unit of claim 14, wherein a space in which the support body and the dielectric plate are apart from each other is defined as a gas channel through which the process gas flows, and
wherein the baffle ring is disposed in the buffer space.

16. The upper electrode unit of claim 14 or 15, wherein the baffle ring comprises a porous material having a plurality of through holes through which the process gas flows.

17. The upper electrode unit of claim 14 or 15, wherein the baffle ring comprises a perforated plate having a through hole through which the process gas flows.

18. The upper electrode unit of claim 17, wherein the through hole is formed in an inclined direction when viewed from a front cross-section.

19. The upper electrode unit of claim 14 or 15, further comprising an upper edge electrode supported on an edge region of the support body when viewed from above and configured to surround the dielectric plate.

20. The upper electrode unit of claim 19, when the upper edge electrode and the dielectric plate are apart from each other when viewed from above, and a space in which the upper edge electrode and the dielectric plate are apart from each other is defined as a gas discharge unit that discharges the process gas flowing through the gas channel to an edge region of the substrate.

## Amended claims

### Amended claims under Art. 19.1 PCT

1. A substrate processing apparatus comprising:
a housing having an interior space;
a lower electrode unit supporting a substrate in the interior space; an upper electrode unit facing the lower electrode unit; and
a gas supply unit supplying a process gas to the interior space, wherein the upper electrode unit comprises:
a dielectric plate facing an upper surface of the substrate supported by the lower electrode unit;
a support body supporting the dielectric plate, wherein the support body and the dielectric plate are combined with each other to form a buffer space and the gas supply unit supplies the process gas to the interior space via the buffer space; and
a baffle member disposed on a flow path of the process gas flowing from the buffer space to the interior space.

2. The substrate processing apparatus of claim 1, wherein a space in which the support body and the dielectric plate are apart from each other is defined as a gas channel through which the process gas flows, the gas channel being in fluid communication with the internal space, and
wherein the baffle member is disposed in the buffer space.

3. The substrate processing apparatus of claim 1, wherein the baffle member comprises a porous material to allow the process gas to flow.

4. The substrate processing apparatus of claim 3, wherein the baffle member comprises a porous ceramic having a plurality of through holes through which the process gas flows.

5. The substrate processing apparatus of claim 1, wherein the baffle member comprises a perforated plate having a through hole through which the process gas flows.

6. The substrate processing apparatus of claim 5, wherein the baffle member comprises a material including a metal.

7. The substrate processing apparatus of claim 2, wherein the upper electrode unit further comprises an upper edge electrode supported by the support body and provided to surround the dielectric plate when viewed from above.

8. The substrate processing apparatus of claim 7, wherein a diameter of an inner periphery of the upper edge electrode viewed from above is greater than a diameter of an outer periphery of the dielectric plate.

9. The substrate processing apparatus of claim 8, wherein a space in which the upper edge electrode and the dielectric plate are apart from each other is defined as a gas discharge unit that discharges the process gas flowing through the gas channel to an edge region of the substrate supported by the lower electrode unit, the gas discharge unit being in fluid communication with the gas channel and the interior space.

10. The substrate processing apparatus of any one of claims 7 to 9, wherein the lower electrode unit comprises:
a chuck supporting the substrate;
an insulating ring configured to surround the chuck when viewed from above; and a lower edge electrode configured to surround the insulating ring when viewed
from above.

11. The substrate processing apparatus of claim 10, wherein the lower electrode unit further comprises a power member configured to apply radio frequency (RF) power to the chuck.

12. The substrate processing apparatus of any one of claims 1 to 9, wherein the gas supply unit comprises:
a gas supply source supplying the process gas in which a plurality of gases of different types are mixed; and
a gas supply line supplying the process gas to the buffer space.

13. The substrate processing apparatus of claim 12, wherein the gas supply source is configured to supply the process gas including at least two of O2, N2, Ar, SF6, and CF4.

14. An upper electrode unit of a bevel etch apparatus for processing an edge region of a substrate, the upper electrode unit comprising:
a dielectric plate facing the substrate;
a support body supporting the dielectric plate, wherein the support body and the dielectric plate define a buffer space that is a space to which a process gas including at least two different types of gases is supplied; and
a baffle ring disposed on a flow path of the process gas flowing from the buffer space toward an edge region of the substrate.

15. The upper electrode unit of claim 14, wherein a space in which the support body and the dielectric plate are apart from each other is defined as a gas channel through which the process gas flows, and
wherein the baffle ring is disposed in the buffer space.

16. The upper electrode unit of claim 14 or 15, wherein the baffle ring comprises a porous material having a plurality of through holes through which the process gas flows.

17. The upper electrode unit of claim 14 or 15, wherein the baffle ring comprises a perforated plate having a through hole through which the process gas flows.

18. The upper electrode unit of claim 17, wherein the through hole is formed in an inclined direction when viewed from a front cross-section.

19. The upper electrode unit of claim 14 or 15, further comprising an upper edge electrode supported on an edge region of the support body when viewed from above and configured to surround the dielectric plate.

20. The upper electrode unit of claim 19, when the upper edge electrode and the dielectric plate are apart from each other when viewed from above, and a space in which the upper edge electrode and the dielectric plate are apart from each other is defined as a gas discharge unit that discharges the process gas flowing through the gas channel to an edge region of the substrate.
